# EUROPEAN PATENT APPLICATION

(11) **EP 4 665 117 A2**
(43) Date of publication of application: **17.12.2025**
(21) Application number: 25181312.7
(22) Date of filing: 06.06.2025
(51) Int. Cl.: H10F 30/225, H10F 71/00

(54) **SINGLE PHOTON AVALANCHE DIODE DEVICE AND METHOD OF MANUFACTURING THE SAME**

(30) Priority: 12.06.2024 JP 2024094989; 04.12.2024 KR 20240178882
(71) Applicant: Samsung Electronics Co., Ltd., Suwon-si, Gyeonggi-do 16677 (KR)
(72) Inventor: NAGANO, Takashi, Yokohama, Kanagawa 230-0027 (JP); YANAGITA, Takeshi, Yokohama, Kanagawa 230-0027 (JP); MIZUNO, Ikuo, Yokohama, Kanagawa 230-0027 (JP)
(74) Representative: Kuhnen & Wacker Patent- und Rechtsanwaltsbüro PartG mbB

(57) **Abstract**

A single photon avalanche diode, SPAD, device (100) may include a substrate (510) including a trench (103) for separating the SPAD device (100) from another SPAD device (100), a semiconductor film (102) of a first conductivity-type on a sidewall of the trench (103), a first insulating film (101) in the trench (103) and covering the semiconductor film (102), an anode electrode layer (105) of the first conductivity-type and in contact with the semiconductor film (102), a cathode electrode layer (106) positioned closer to a first surface of the substrate (510) compared to the anode electrode layer (105) and including a first semiconductor layer (106a) of a second conductivity-type and a conductor layer (106b) in contact with the first semiconductor layer (106a), a second insulating film (108) covering a sidewall of the conductor layer (106b), and a second semiconductor layer of the first conductivity type in contact with the first semiconductor layer (106a). The conductor layer (106b) may be closer to a second surface of the substrate (510) compared to the first semiconductor layer (106a).

## Description

### BACKGROUND

The inventive concept relates to a single photon avalanche diode (SPAD) device and/or a method of manufacturing the SPAD device.

Recently, SPADs that amplify charges generated by the photoelectric conversion of incident light through avalanche amplification and output the same as an electrical signal has come to prominence. SPADs are photon counting sensors that may detect individual particles of light and count incident photons one by one for each pixel with extremely high time resolution and it has attracted attention as a technology that enables high dynamic range and noise-free reading.

To produce avalanche amplification, it is necessary to apply a high voltage of reverse bias to a PN junction. However, if a distance between the PN junction and a power contact decreases due to progression of fine pixel integration, a strong electric field may be formed between the PN junction and the power contact, which may cause leakage current or tunneling current. These currents may be amplified in a strong current field even in the dark state in which light does not reach, and there is a risk that the currents may be detected as false signals and become noise.

A solid-state imaging device described below is disclosed in WO 2020/203222.

A semiconductor substrate having a plurality of photoelectric conversion devices includes a first trench in a grid shape on a first surface and a second trench installed along a bottom of the first trench. Each photoelectric conversion device has a photoelectric conversion region that converts incident light into charges within a device region defined by a first trench and a second trench. Each photoelectric conversion device includes a first semiconductor region surrounding a photoelectric conversion region within the device region, a first contact contacting the first semiconductor region at the bottom of the first trench, and a first electrode contacting the first contact within the first trench. Each photoelectric conversion device includes a second semiconductor region, which is disposed in a region in contact with the first semiconductor region within the device region and has a first conductivity type which is the same as that of the first semiconductor region. Each photoelectric conversion device includes a third semiconductor region which is a region in contact with the second semiconductor region within the device region, is disposed between the second semiconductor region and the first surface, and has a second conductivity type opposite to the first conductivity type. Each photoelectric conversion device includes a second contact disposed on the first surface so as to be in contact with the third semiconductor region and a second electrode in contact with the second contact. The height of the first contact from the first surface is different from the height of the third semiconductor region from the first surface.

### SUMMARY

However, in the above related art, there is a possibility that noise characteristics may deteriorate due to leakage current, etc., from an anode electrode within the trench. Due to a limitation in the miniaturization of a cathode electrode, the volume of a high-electric field region may increase, which makes it difficult to reduce noise. In addition, the related art cannot achieve low power consumption due to low capacitance of the cathode electrode.

The inventive concept provides a single photon avalanche diode (SPAD) device and/or a method of manufacturing the SPAD device capable of reducing noise and power consumption by limiting and/or preventing deterioration of noise characteristics caused by leakage current, etc. and reducing the volume of a high electric field region.

According to an aspect of the inventive concept, a SPAD device may include a substrate including a trench for separating the SPAD device from another SPAD device; a semiconductor film of a first conductivity-type on a sidewall of the trench; a first insulating film in the trench and covering the semiconductor film; an anode electrode layer of the first conductivity-type, the anode electrode layer being in contact with the semiconductor film; a cathode electrode layer positioned closer to a first surface of the substrate compared to the anode electrode layer, the first surface of the substrate being a light incident surface, the cathode electrode layer having a first semiconductor layer of a second conductivity-type and a conductor layer in contact with the first semiconductor layer, and the conductor layer being positioned closer to a second surface of the substrate compared to the first semiconductor layer, the second surface of the substrate being opposite the first surface of the substrate; a second insulating film covering a sidewall of the conductor layer; and a second semiconductor layer of the first conductivity-type, the second semiconductor layer being in contact with the first semiconductor layer.

According to another aspect of the inventive concept, a SPAD device may include a substrate including a first surface and a second surface opposing the first surface, the substrate including a trench defining a plurality of device regions and extending between the plurality of device regions in the substrate, and the first surface of the substrate being a light incident surface; a semiconductor film of a first conductivity-type on a sidewall of the trench; a first insulating film in the trench and covering the semiconductor film; an anode electrode layer of the first conductivity-type, the anode electrode layer being adjacent to the second surface of the substrate and in contact with the semiconductor film; a cathode electrode layer adjacent to the second surface of the substrate, the cathode electrode layer including a conductor layer of the first conductivity-type and a first semiconductor layer in the substrate, the first semiconductor layer vertically overlapping the conductor layer and being in contact with the conductor layer; a second insulating film surrounding a sidewall of the conductor layer; and a second semiconductor layer of the first conductivity-type in contact with the first semiconductor layer.

According to another aspect of the inventive concept, a SPAD device may include a substrate including a first surface and a second surface opposing the first surface, the substrate including a trench defining a plurality of device regions and extending between the plurality of device regions in the substrate, and the first surface of the substrate being a light incident surface; a semiconductor film of a first conductivity-type on a sidewall of the trench; a first insulating film in the trench and covering the semiconductor film; an anode electrode layer of the first conductivity-type, the anode electrode layer being adjacent to the second surface of the substrate and in contact with the semiconductor film; a cathode electrode layer adjacent to the second surface of the substrate, the cathode electrode layer including a conductor layer of the first conductivity-type and a first semiconductor layer formed in the substrate, the first semiconductor layer vertically overlapping the conductor layer and being in contact with the conductor layer; a second insulating film surrounding a sidewall of the conductor layer; a second semiconductor layer of the first conductivity-type and in contact with the first semiconductor layer; and a third semiconductor layer of the first conductivity-type and surrounding a sidewall of the second semiconductor layer in a plan view. A sidewall of the third semiconductor layer may contact a sidewall of the semiconductor film.

According to another aspect of the inventive concept, a method of manufacturing an SPAD device may include operation (a) of forming a trench in a substrate for defining and separating a plurality of SPAD devices formed on the substrate from each other, forming a semiconductor film of a first conductivity-type on a sidewall of the trench, and forming a first insulating film covering the semiconductor film in the trench; operation (b) of forming a first internal trench in a region defined by the trench; operation (c) of forming a second insulating film covering a sidewall of the first internal trench; operation (d) of implanting impurities through the second insulating film at a bottom of the first internal trench to form a second semiconductor layer of the first conductivity-type and a first semiconductor layer of a second conductivity-type in contact with the second semiconductor layer; operation (e) of removing, by etching, the second insulating film at the bottom of the first internal trench; operation (f) of filling the first internal trench with a material of the second conductivity-type to form a conductor layer in contact with the first semiconductor layer; and operation (g) of implanting an impurity into the substrate to form an anode electrode layer of the first conductivity-type in contact with the semiconductor film.

According to another aspect of the inventive concept, a method of manufacturing an SPAD device may include operation (a) of forming a trench in a substrate for defining and separating a plurality of SPAD devices from each other, forming a semiconductor film of a first conductivity-type on a sidewall of the trench, and forming a first insulating film covering the semiconductor film in the trench; operation (h) of implanting a first impurity into the substrate to form a third semiconductor layer of the first conductivity-type in a region defined by the trench such that the third semiconductor layer contacts opposing sidewall portions of the semiconductor layer; operation (b) of forming a first internal trench in the region defined by the trench; operation (c) of forming a second insulating film covering a sidewall of the first internal trench; operation (d1) of implanting a second impurity through the second insulating film at a bottom of the first internal trench to form a second semiconductor layer of the first conductivity-type in a portion of the third semiconductor layer; operation (d2) of implanting a third impurity through the second insulating film at the bottom of the first internal trench to form a first semiconductor layer of a second conductivity-type, the first semiconductor layer being in contact with the second semiconductor layer; operation (e) of removing, by etching, the second insulating film at the bottom of the first internal trench; operation (f) of filling the first internal trench with a material of the second conductivity-type to form a conductor layer in contact with the first semiconductor layer; and operation (g) of implanting a fourth impurity into the substrate to form an anode electrode layer of the first conductivity-type, the anode electrode layer being in contact with the semiconductor film.

According to another aspect of the inventive concept, a method of manufacturing an SPAD device may include operation (A) of forming a trench in a substrate for defining and separating a plurality of SPAD devices from each other, forming a semiconductor film of a first conductivity-type on a sidewall of the trench, and forming a first insulating film covering the semiconductor film in the trench; operation (B1) of depositing a first insulating material on the substrate to form a fourth insulating film on the substrate; operation (B2) of forming two second internal trenches penetrating the fourth insulating film within a region defined by the trench; operation (C) of depositing second insulating material on the substrate to fill the two second internal trenches with the second insulating material to form a second insulating film; operation (D) of implanting impurities through the fourth insulating film between the two second internal trenches to form a second semiconductor layer of the first conductivity-type, a first semiconductor layer of a second conductivity-type in contact with the second semiconductor layer, and a conductor layer of the second conductivity-type in contact with the first semiconductor layer, the conductor layer having a sidewall covered with the second insulating film; and operation (E) of implanting an impurity into the substrate through the fourth insulating film to form an anode electrode layer of the first conductivity-type, the anode electrode layer being in contact with the semiconductor film.

According to another aspect of the inventive concept, a method of manufacturing an SPAD device may include operation (A) of forming a trench in a substrate for defining and separating a plurality of SPAD devices from each other, forming a semiconductor film of a first conductivity-type on a sidewall of the trench, and forming a first insulating film covering the semiconductor film in the trench; operation (F) of implanting a first impurity into the substrate to form a third semiconductor layer of the first conductivity-type in a region defined by the trench such that the third semiconductor layer contacts opposing sidewall portions of the semiconductor layer; operation (B1) of depositing a first insulating material on the substrate to form a fourth insulating film on the substrate; operation (B2) of forming two second internal trenches penetrating the fourth insulating film within the region defined by the trench; operation (C) of depositing a second insulating material on the substrate to fill the two second internal trenches with the second insulating material to form a second insulating film; operation (D1) of implanting a second impurity through the fourth insulating film between the two second internal trenches to form a second semiconductor layer of the first conductivity-type in a portion of the third semiconductor layer; operation (D2) of implanting a third impurity through the fourth insulating film between the two second internal trenches to form a first semiconductor layer of a second conductivity-type in contact with the second semiconductor layer and a conductor layer of the second conductivity-type in contact with the first semiconductor layer, the conductor layer having a sidewall covered with the second insulating film; and operation (E) of implanting a fourth impurity into the substrate through the fourth insulating film to form an anode electrode layer of the first conductivity-type and in contact with the semiconductor film.

According to another aspect of the inventive concept, an image sensor may include a pixel array including a plurality of SPAD pixels on a substrate, the substrate including a trench for separating and defining the plurality of SPAD pixels; a driving circuit connected to the pixel array; an output circuit connected to the pixel array; and a control circuit connected to the driving circuit and the pixel circuit. Each of the plurality of SPAD pixels may include a SPAD device. The SPAD device may include a semiconductor film of a first conductivity-type on a sidewall of the trench; a first insulating film in the trench and covering the semiconductor film; an anode electrode layer of the first conductivity-type, the anode electrode layer being in contact with the semiconductor film; a cathode electrode layer positioned closer to a first surface of the substrate compared to the anode electrode layer, the first surface of the substrate being a light incident surface, the cathode electrode layer having a first semiconductor layer of a second conductivity-type and a conductor layer in contact with the first semiconductor layer, and the conductor layer being positioned closer to a second surface of the substrate compared to the first semiconductor layer, the second surface of the substrate being opposite the first surface of the substrate; a second insulating film covering a sidewall of the conductor layer; and a second semiconductor layer of the first conductivity-type, the second semiconductor layer being in contact with the first semiconductor layer.

In some embodiments, each of the plurality of SPAD pixels may include a logic device, and the logic device may include a quench resistor and an inverter.

In some embodiments, the anode electrode layer may be coplanar with the second surface of the substrate.

In some embodiments, the conductor layer may include at least one of single crystal silicon, polysilicon, or a metal.

In some embodiments, a width of the first semiconductor layer may be greater than or equal to a width of the conductor layer and less than or equal to a width of a combination of the conductor layer and the second insulating film.

### BRIEF DESCRIPTION OF THE DRAWINGS

Embodiments will be more clearly understood from the following detailed description taken in conjunction with the accompanying drawings in which:
FIG. 1 is a block diagram illustrating a schematic configuration of an image sensor;
FIG. 2 is a circuit diagram illustrating an example of a schematic configuration of a single photon avalanche diode (SPAD) pixel;
FIG. 3 is a diagram illustrating a stack structure of a pixel array;
FIG. 4A is a cross-sectional view illustrating a structure of a SPAD device;
FIG. 4B is a plan view taken along line A-A in FIG. 4A;
FIG. 5 is a diagram illustrating the potential of a photoelectric conversion region, etc.;
FIG. 6 is a diagram illustrating a method of manufacturing a SPAD device;
FIG. 7 is a flowchart illustrating a main process of the method of manufacturing a SPAD device corresponding to FIG. 6;
FIG. 8 is a cross-sectional view illustrating a structure of a SPAD device;
FIG. 9 is a diagram illustrating a method of manufacturing a SPAD device;
FIG. 10 is a flowchart illustrating a main process of the method of manufacturing a SPAD device corresponding to FIG. 9;
FIG. 11 is a diagram illustrating a method of manufacturing a SPAD device;
FIG. 12 is a flowchart illustrating the main process of the method of manufacturing a SPAD device corresponding to FIG. 11;
FIG. 13 is a flowchart illustrating the main process of a method of manufacturing a SPAD device;
FIG. 14A is a cross-sectional view illustrating a structure of a SPAD device;
FIG. 14B is a plan view taken along line A-A in FIG. 14A;
FIG. 14C is a plan view illustrating another structure of a second insulating film;
FIG. 15A is a cross-sectional view illustrating a structure of a SPAD device;
FIG. 15B is a plan view taken along line A-A in FIG. 15A;
FIG. 15C is a plan view illustrating another structure of the second insulating film;
FIG. 16 is a cross-sectional view illustrating a structure of a SPAD device; and
FIG. 17 is a cross-sectional view illustrating a structure of a SPAD device.

### DETAILED DESCRIPTION OF THE EMBODIMENTS

Hereinafter, a single photon avalanche diode (SPAD) device and a method of manufacturing a SPAD device according to an embodiment are described in detail with reference to the drawings. The described embodiments are merely an example, and various modifications may be made from these embodiments. Hereinafter, in the drawings, like reference numerals refer to like components, and the size of each component in the drawings is expressed in a different ratio than the actual size for the sake of description and convenience of explanation.

Hereinafter, the expressions "upper" or "above" include not only components that are directly above/below/left/right in contact, but also components that are directly above/below/left/right in non-contact.

Terms, such as first and second, are used to describe various components, but are only used to distinguish one component from another. Such terms do not limit the material or structure of the components to others.

A component expressed in the singular includes plural components unless the context clearly indicates otherwise. Also, when a component "includes" a part, this means that it may include other components, rather than excluding other components, unless otherwise in detail stated.

In addition, terms, such as "part" and "module," described in the specification refer to a unit that processes one or more functions or operations, which is implemented by hardware or software or by a combination of hardware and software.

### (First embodiment)

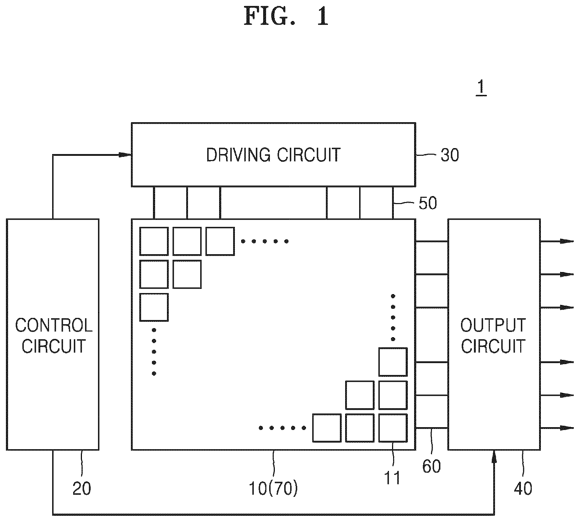

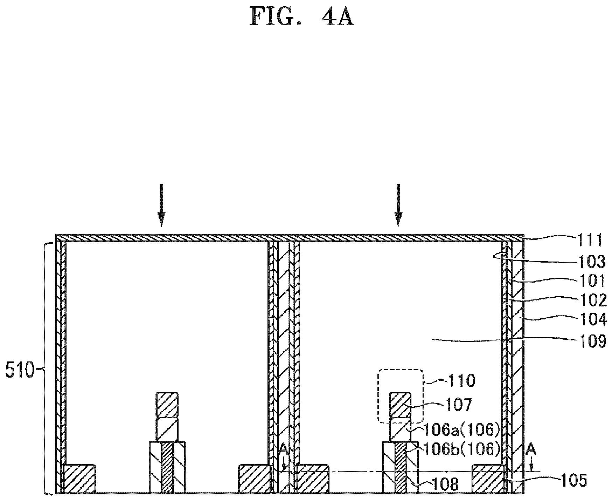

FIG. 1 is a block diagram illustrating a schematic configuration of an image sensor 1. In some embodiments, the image sensor 1 may be a back face illumination type image sensor 1. In other embodiments, the image sensor 1 may be a front face illumination type image sensor 1. The back face illustration type image sensor 1 (backside-illuminated image sensor) may have a light-incident surface on the side opposite to a device formation surface of a semiconductor substrate 510 (see FIG. 4A). The front face illustration type image sensor 1 (frontside-illuminated image sensor) may have a device formation surface that is a light-incident surface. Hereinafter, to simplify the description, the image sensor 1 is described as the back face illustration type image sensor 1, for example. The semiconductor substrate 510 constitutes a substrate.

The image sensor 1 may include a pixel array 10, a control circuit 20, a driving circuit 30, and an output circuit 40.

The pixel array 10 includes a plurality of SPAD pixels 11 arranged in a matrix form. To each SPAD pixel 11, a pixel driving line 50 is connected in each column and an output signal line 60 is connected in each row. The pixel driving line 50 is connected to an output terminal corresponding to each column of the driving circuit 30. The output signal line 60 is connected to an input terminal corresponding to each row of the output circuit 40.

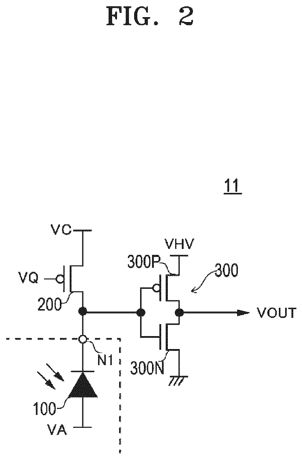

The driving circuit 30 includes a shift register or an address decoder and drives all SPAD pixels 11 of the pixel array 10 simultaneously or by column. The driving circuit 30 includes a circuit that applies a quench voltage VQ (see FIG. 2) described below to each SPAD pixel 11. The driving circuit 30, when driving each SPAD pixel 11 by column, may include a circuit that applies a selection signal voltage VSEL (see FIG. 2) to each SPAD pixel 11 of a selected column. In this case, each SPAD pixel 11 is selected by the selection signal voltage VSEL, and a power voltage is applied only to the selected SPAD pixel 11, so that a detection signal VOUT (see FIG. 2) is output from the corresponding SPAD pixel 11.

The detection signal VOUT output from each SPAD pixel 11 is input to the output circuit 40 through each output signal line 60. The output circuit 40 outputs the detection signal VOUT input from each SPAD pixel 11 as an image signal.

The control circuit 20 includes a timing generator that generates various timing signals and controls the driving circuit 30 and the output circuit 40 based on various timing signals generated by the timing generator.

FIG. 2 is a circuit diagram illustrating an example of a schematic configuration of the SPAD pixel 11.

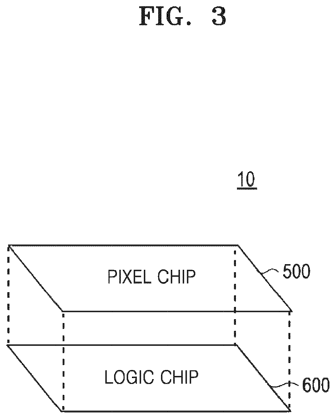

The SPAD pixel 11 includes a SPAD device 100, a quench resistor 200, and an inverter 300. As described below, the SPAD device 100 may be formed in a pixel chip 500 (see FIG. 3), and the quench resistor 200 and inverter 300 may be formed in a logic chip 600. Each SPAD pixel 11 is formed as the pixel chip 500 and the logic chip 600 are aligned and bonded in position at each SPAD pixel 11. In FIG. 2, a connection point at which the SPAD device 100 and the quench resistor 200 are connected by the bonding between the pixel chip 500 and the logic chip 600 is shown as a node N1. In addition, the boundary between the pixel chip 500 and the logic chip 600 is indicated by a dashed line.

The SPAD device 100 is a light-receiving device, and when a photon is incident while a reverse bias higher than a breakdown voltage is applied between an anode and a cathode, an avalanche current is generated. An anode voltage VA is applied to the anode of the SPAD device 100, and a cathode voltage VC is applied to the cathode of the SPAD device 100 through the quench resistor 200. In embodiments, the anode voltage VA is set to -15 V to -30 V. In embodiments, the cathode voltage VC is set to 3 V. The SPAD device 100 may detect one photon by operating in a Geiger mode when a reverse bias voltage equal to or higher than the breakdown voltage is applied.

In embodiments, the quench resistor 200 includes a P-channel metal oxide semiconductor (PMOS) transistor. The quench resistor 200 operates as a quench resistor when a quench voltage VQ supplied from the driving circuit 30 is applied to a gate thereof. In addition, the quench resistor 200 has a function of a recharge operation of returning a voltage supplied to the SPAD device 100 to the cathode voltage VC by applying a current equivalent to a voltage drop caused by a quench operation.

The current flowing through the SPAD device 100 is converted into voltage by the quench resistor 200 and output to the inverter 300.

The inverter 300 is configured by connecting a PMOS transistor 300P and an NMOS transistor 300N in series. A power VHV for driving a digital circuit is connected to a source of the PMOS transistor 300P, and a drain of the NMOS transistor 300N is connected to a drain of the PMOS transistor 300P. A source of the NMOS transistor 300N is grounded. A gate of the PMOS transistor 300P is connected to a gate of the NMOS transistor 300N, and a connection point thereof becomes an input of the inverter 300. A connection point between the drain of the PMOS transistor 300P and the drain of the NMOS transistor 300N becomes an output of the inverter 300. The input of the inverter 300 is connected to the node N1, which is the connection point between the SPAD device 100 and the quench resistor 200.

The inverter 300 converts an input voltage into a digital signal and outputs the digital signal as a detection signal VOUT. In addition, because a buffer for impedance conversion is installed in the output of the inverter 300, the impedance-converted detection signal VOUT may be output from each SPAD pixel 11.

The detection signal VOUT is input to the output circuit 40. The output circuit 40 (see FIG. 1) outputs the detection signal VOUT to a processor (not shown) through, for example, a time to digital converter (TDC) (not shown). The detection signal VOUT undergoes various processing by the processor.

Below, the operation of the SPAD pixel 11 is described.

When a photon is incident on the SPAD device 100 while a reverse bias voltage VSPAD equal to or higher than the breakdown voltage is applied to the SPAD device 100 through the quench resistor 200, an avalanche current is generated in the SPAD device 100. The reverse bias voltage VSPAD is the sum of an absolute value of the anode voltage VA and an absolute value of the cathode voltage VC. As the avalanche current flows through the quench resistor 200, the voltage at the node N1 drops. When the voltage at the node N1 is lower than a threshold voltage of the PMOS transistor 300P of the inverter 300, the PMOS transistor 300P conducts, so that the power VHV from the inverter 300 is output as a high-level detection signal.

Thereafter, as the voltage of the node N1 continues to decrease, the voltage applied to the SPAD device 100 becomes lower than the breakdown voltage. Accordingly, the avalanche current stops flowing and the voltage at the node N1 increases. When the voltage at the node N1 is higher than the threshold voltage of the NMOS transistor 300N of the inverter 300, the NMOS transistor 300N conducts and a ground voltage is output from the inverter 300 as a low-level detection signal.

FIG. 3 is a diagram illustrating a stack structure of the pixel array 10.

The SPAD pixels 11 are arranged in an array shape to form the pixel array 10. The SPAD device 100 forms a device array 70 as the SPAD pixels 11 are arranged in an array shape. The pixel array 10 has a structure in which the pixel chip 500 and the logic chip 600 are stacked. The pixel chip 500 is a semiconductor chip in which SPAD devices 100 are formed in an array shape. The logic chip 600 is a semiconductor chip in which the quench resistor 200 and the inverter 300 are formed in positions corresponding to each SPAD device 100. The logic chip 600 may further include the control circuit 20, the driving circuit 30, and the output circuit 40. The logic chip 600 may further include the aforementioned buffer for impedance-converting the detection signal VOUT.

In embodiments, the pixel chip 500 and the logic chip 600 may be bonded by force between electrons by flattening each of bonding surfaces and bringing them into contact. In detail, the pixel chip 500 and the logic chip 600 may be bonded by metal bonding between metal pads formed on respective surfaces (bonding surfaces) thereof.

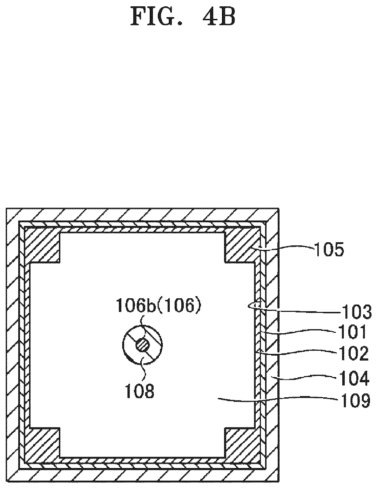

FIG. 4A is a cross-sectional view illustrating a structure of the SPAD device 100. FIG. 4B is a plan view of the A-A surface in FIG. 4A. In FIG. 4A, two adjacent SPAD devices 100 are shown to clearly illustrate the configuration of a trench 103 arranged between adjacent SPAD devices 100.

The surface on which light is incident, indicated by the thick arrows in FIG. 4A, is also referred to as a light incident surface of the semiconductor substrate 510. The light incident surface constitutes a first surface. A surface opposite to the light incident surface of the semiconductor substrate 510 constitutes a second surface.

A plurality of SPAD devices 100 are formed on the semiconductor substrate 510 that constitutes the pixel chip 500. In embodiments, the semiconductor substrate 510 may include a single crystal silicon substrate.

Each SPAD device 100 includes a trench 103 to separate one SPAD device 100 from another adjacent SPAD device 100. The trenches 103 of a plurality of SPAD devices 100 formed on or within the semiconductor substrate 510 are connected to each other, so that they may have a grid shape when viewed in a plane from the light incident surface.

A photoelectric conversion region 109 is a region that photoelectrically converts incident light to generate pairs of electrons and holes. The photoelectric conversion region 109 is designed with a potential so that electrons generated by photoelectric conversion gather in an avalanche region 110, as described below.

In embodiments, a semiconductor film 102 may have a first conductivity type. The first conductivity type may be, for example, P-type. The semiconductor film 102 may be formed on a sidewall of the trench 103. The semiconductor film 102 may be formed by implanting an impurity, for example, boron (B). In embodiments, the semiconductor film 102 may be in contact with an anode electrode layer 105. The semiconductor film 102 may form an electric field to induce electrons generated in the photoelectric conversion region 109 to the avalanche region 110 by applying a reverse bias voltage VSPAD between the anode electrode layer 105 and a cathode electrode layer 106.

In embodiments, the anode electrode layer 105 may be formed to be in contact with the semiconductor film 102. The anode electrode layer 105 may have a first conductive type. The first conductivity type may be, for example, P-type.

In embodiments, the anode electrode layer 105 may be in contact with the opposite side the second surface) of the light incident surface. As illustrated in FIG. 4B, the anode electrode layer 105 may be placed at four corners of one SPAD device 100. However, the planar arrangement of the anode electrode layer 105 is not limited to that shown in FIG. 4B.

In embodiments, a first insulating film 101 covering the semiconductor film 102 may be formed inside the trench 103. The first insulating film 101 may be formed, for example, by depositing silicon oxide (SiO₂) on the semiconductor film 102 by a chemical vapor deposition (CVD) process.

In embodiments, the cathode electrode layer 106 may include a first semiconductor layer 106a and a conductor layer 106b. The first semiconductor layer 106a may be in contact with the conductor layer 106b. A sidewall of the conductor layer 106b may be covered by a second insulating film 108. The first semiconductor layer 106a and the conductor layer 106b may have a second conductivity type. The second conductivity type may be, for example, N-type.

Below, for simplification, a case in which the first conductivity type is P-type and the second conductivity type is N-type is described as an example.

In embodiments, the conductor layer 106b may include at least one of single crystal silicon, polysilicon, or a metal.

In embodiments, the second insulating film 108 may include a silicon oxide film (a film including silicon oxide (SiO₂)).

In embodiments, the width of the first semiconductor layer 106a may be greater than or equal to the width of the conductor layer 106b and less than or equal to the width of a combination of the conductor layer 106b and the second insulating film 108, e.g. in a horizontal direction parallel to the light incident surface and/or parallel to the device formation surface. In some embodiments, the width of the combination of the conductor layer 106b and the second insulating film 108 may correspond to the sum of the width of the conductor layer 106b, the width of the portion of the second insulating film 108 disposed on a first side surface of the conductor layer 106b, and the width of the portion of the second insulating film 108 disposed on a second side surface of the conductor layer 106b opposite to the first side surface in a vertical cross-section of the SPAD device.

In embodiments, a second semiconductor layer 107 may be disposed within the semiconductor substrate 510 and may be in contact with the first semiconductor layer 106a. In embodiments, the second semiconductor layer 107 may be positioned to vertically overlap the first semiconductor layer 106a, and a distance between the second semiconductor layer 107 and the second surface (e.g., the surface opposite to the light incident surface) of the semiconductor substrate 510 may be greater than a distance between the first semiconductor layer 106a and the second surface of the semiconductor substrate 510. The second semiconductor layer 107 may be a P-type semiconductor layer. A PN junction of the SPAD device 100 is formed by bonding the P-type second semiconductor layer 107 and the first semiconductor layer 106a that is N-type.

As the anode electrode layer 105 is formed in a position in contact with the opposite surface (the second surface) opposite to the light incident surface, and the first semiconductor layer 106a of the cathode electrode layer 106 is formed with the conductor layer 106b having the sidewall covered with the second insulating film 108 therebetween, so that a distance between the anode and the cathode in the SPAD device 100 may increase. That is, by forming a structure in which the first semiconductor layer 106a of the cathode electrode layer 106 is embedded within the photoelectric conversion region 109, the distance between the anode electrode layer 105 and the portion of the cathode electrode layer 106 that is not covered by the second insulating film 108 (e.g., the first semiconductor layer 106a) may be increased (e.g. compared to the prior art). Accordingly, the magnitude of an electric field between the anode and the cathode in the SPAD device 100 may be alleviated, thereby limiting and/or preventing deterioration of noise characteristics due to leakage current, etc.

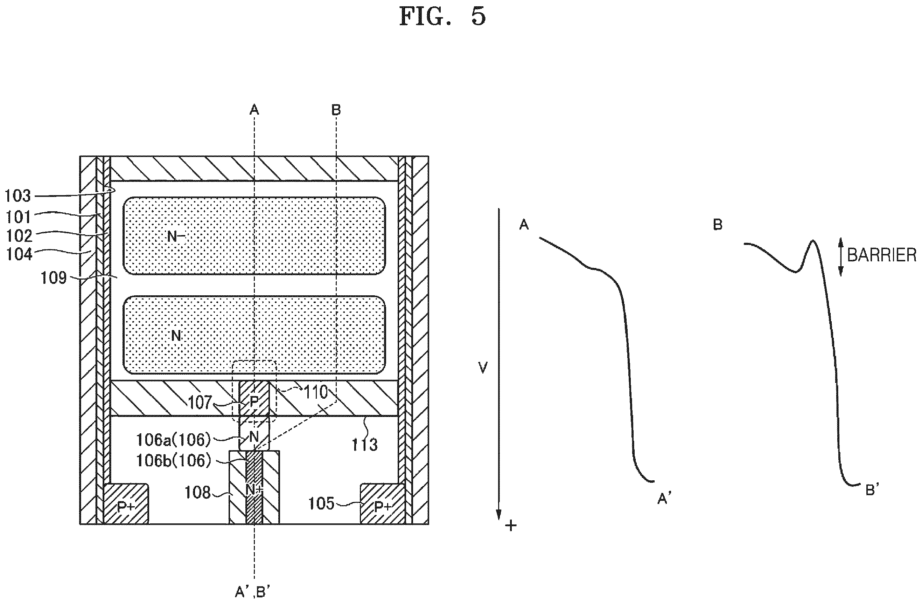

FIG. 5 is a diagram illustrating a potential of the photoelectric conversion region 109, etc. In FIG. 5, the potential along line A-A' and the potential along line B-B' in a cross-sectional view illustrating the structure of the SPAD device 100 are shown. In the example of FIG. 5, the cathode voltage VC applied to the cathode electrode layer 106 is 3 V, and the anode voltage VA applied to the anode electrode layer 105 is -15 V.

In the cross-sectional view of FIG. 5, the region in which the symbol "P+" appears indicates a region having a acceptor concentration higher than an acceptor (impurity) concentration (indicated by the reference letter "P") of the second semiconductor layer 107. The region in which the symbol "N+" appears indicates a region having a donor concentration higher than a donor (impurity) concentration (indicated by the reference letter "N") of the first semiconductor layer 106a. The region in which the symbol "N-" appears indicates a region having a donor concentration lower than the donor concentration of the first semiconductor layer 106a.

The potential along the line A-A' in the center of the photoelectric conversion region 109 is designed as a potential in which electrons generated by photoelectric conversion gather in the avalanche region 110 without an obstruction. At the potential along the line B-B' at the end of the photoelectric conversion region 109, a barrier is formed so that electrons generated by photoelectric conversion are directed to the avalanche region 110 (so that electrons may not escape to the cathode electrode layer 106, without passing through the avalanche region 110). The barrier may be formed by installing a third semiconductor layer 113 that is a P-type. The third semiconductor layer 113 that is a P-type is described in detail in a second embodiment described below. The height of the barrier may be, for example, 1 to 2 V. In this manner, a potential design may be made so that electrons generated by photoelectric conversion gather in the avalanche region 110.

Referring back to FIGS. 4A and 4B, a P-type trench electrode layer 104 in contact with the first insulating film 101 may be formed inside the trench 103. In this case, an anode voltage VA may be applied to the trench electrode layer 104 together with the anode electrode layer 105. Alternatively, a lower voltage than that of the anode electrode may be applied to the trench electrode layer 104.

An anti-reflection film 111 may be formed on the light incident surface of the semiconductor substrate 510 to prevent reflection of incident light.

A color filter (not shown) corresponding to each SPAD device 100 and an on-chip lens (not shown) may be formed on the anti-reflection film 111. The color filter may be formed as one of a color filter that selectively transmits light of a red (R) wavelength component, a color filter that selectively transmits light of a green (G) wavelength component, and a color filter that selectively transmits light of a blue (B) wavelength component, to correspond to each SPAD device 100. The color filters may be arranged in a Bayer pattern to form a Bayer array.

An interconnection layer (not shown) may be arranged on the surface opposite to the light incident surface of the semiconductor substrate 510. The interconnection layer may include an insulating film and interconnection stacked on top of each other. A plurality of interconnection layers may be stacked with an insulating film therebetween. In this case, adj acent interconnections of the same node with an insulating film therebetween are connected to each other by vias formed in the insulating film. The interconnection may include an anode interconnection for supplying the anode voltage VA to the SPAD device 100 and a cathode interconnection for supplying the cathode voltage VC to the SPAD device 100. The anode interconnection may be connected to the anode electrode layer 105 and the trench electrode layer 104. The cathode interconnection may be connected to the cathode electrode layer 106. The interconnection may include a connection pad. The connection pad may be exposed on the surface of the interconnection layer.

The connection pad may be bonded to a connection pad exposed on the surface of the logic chip 600 using a metal bonding method. Accordingly, the pixel chip 500 may be bonded to the logic chip 600.

The logic chip 600 may include a substrate and an interconnection layer. In this case, a device constituting a logic circuit, including transistors constituting the quench resistor 200 and the inverter 300, are formed on the substrate. In addition, an interconnection for forming a logic circuit including an interconnection connecting the quench resistor 200 to the inverter 300 or an interconnection including a connection pad is formed in the interconnection layer.

A method of manufacturing the SPAD device 100 is described.

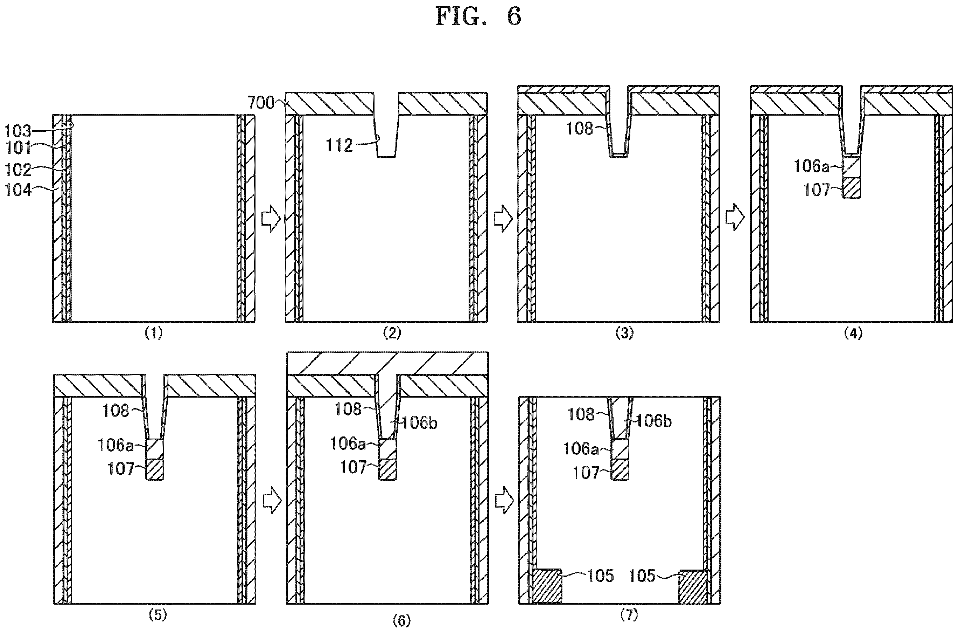

FIG. 6 is a diagram illustrating a method of manufacturing the SPAD device 100.

In operation 1, the trench 103 may be formed to define and separate a plurality of SPAD devices formed on the semiconductor substrate 510 from each other, the semiconductor film 102 may be formed on the sidewall of the formed trench 103, and the first insulating film 101 covering the formed semiconductor film 102 may be formed inside the trench 103. In addition, the trench electrode layer 104 that contacts the first insulating film 101 may be formed inside the trench 103.

The trench 103 may be formed as follows. A hard mask material layer is formed on the semiconductor substrate 510, and a hard mask material layer is etched by plasma etching using a mask in which an opening corresponding to the position of the trench 103 is formed. Then, the semiconductor substrate 510 is etched by plasma etching using the hard mask material layer in which an opening corresponding to the position of the trench 103 is formed by etching as a mask, thereby forming the trench 103.

The semiconductor film 102 may be formed as follows. In embodiments, the P-type semiconductor film 102 is formed on the sidewall of the trench 103 by implanting an acceptor, which is an impurity, through plasma doping and activating the acceptor through heat treatment. For example, boron (B) is used as an acceptor. In other embodiments, the P-type semiconductor film 102 may be formed by depositing a material including boron (e.g., a glass material) within the trench and solid-phase diffusing boron within the material into the semiconductor substrate 510 through heat treatment.

In embodiments, the first insulating film 101 may be formed by depositing silicon oxide (SiO₂) on the semiconductor film 102 by a CVD process.

In embodiments, the trench electrode layer 104 may be formed by depositing polysilicon or a metal within the trench 103 by a CVD process.

In operation 2, a first internal trench 112 is formed within a region defined by the trench 103. The first internal trench 112 may be formed as follows. A hard mask material layer 700 is formed on the semiconductor substrate 510 and etched by plasma etching using a mask in which an opening corresponding to the position of the first internal trench 112 is formed. Then, the first internal trench 112 is formed by etching the semiconductor substrate 510 by plasma etching using the hard mask material layer 700 in which the opening corresponding to the position of the first internal trench 112 is formed by etching, as a mask.

In operation 3, the second insulating film 108 is formed to cover the sidewall of the first internal trench 112. The second insulating film 108 may be formed by depositing silicon oxide (SiO₂) on the semiconductor substrate 510 by an atomic layer deposition (ALD) process. In embodiments, the thickness of the second insulating film 108 deposited on the sidewall of the first internal trench 112 may be controlled using an in-situ stream generator (ISSG).

In operation 4, the P-type second semiconductor layer 107 is formed by implanting an acceptor, which is an impurity, through the second insulating film 108 formed at the bottom of the first internal trench 112 and activating the acceptor through heat treatment. For example, boron (B) is used as the acceptor. Thereafter, a donor, which is an impurity, is implanted through the second insulating film 108 formed at the bottom of the first internal trench 112 and activated by heat treatment to form the first semiconductor layer 106a that is an N-type and in contact with the second semiconductor layer 107. For example, phosphorus (P) or arsenic (As) are used as the donor. In addition, heat treatment may be performed once after implanting the acceptor for forming the second semiconductor layer 107 and the donor for forming the first semiconductor layer 106a.

In operation 5, the second insulating film 108 formed at the bottom of the first internal trench 112 may be removed by etching. The second insulating film 108 formed at the bottom of the first internal trench 112 may be removed, for example by dry etching.

In operation 6, the first internal trench 112 may be filled with an N-type material by depositing an N-type material on the semiconductor substrate 510 by a CVD process or the like, thereby forming the conductor layer 106b in contact with the first semiconductor layer 106a. As the N-type material filling the first internal trench 112, for example, polysilicon implanted with a donor as an impurity may be used. For example, phosphorus (P) or arsenic (As) are used as the donor.

In operation 7, the N-type material deposited on the semiconductor substrate 510 is removed so that the N-type material remains only within the first internal trench 112, and at the same time, the hard mask material layer 700 is removed. The N-type material and hard mask material layer 700 may be removed by dry etching.

Thereafter, by implanting an acceptor, which is an impurity, into the semiconductor substrate 510, the P-type anode electrode layer 105 in contact with the semiconductor film 102 is formed.

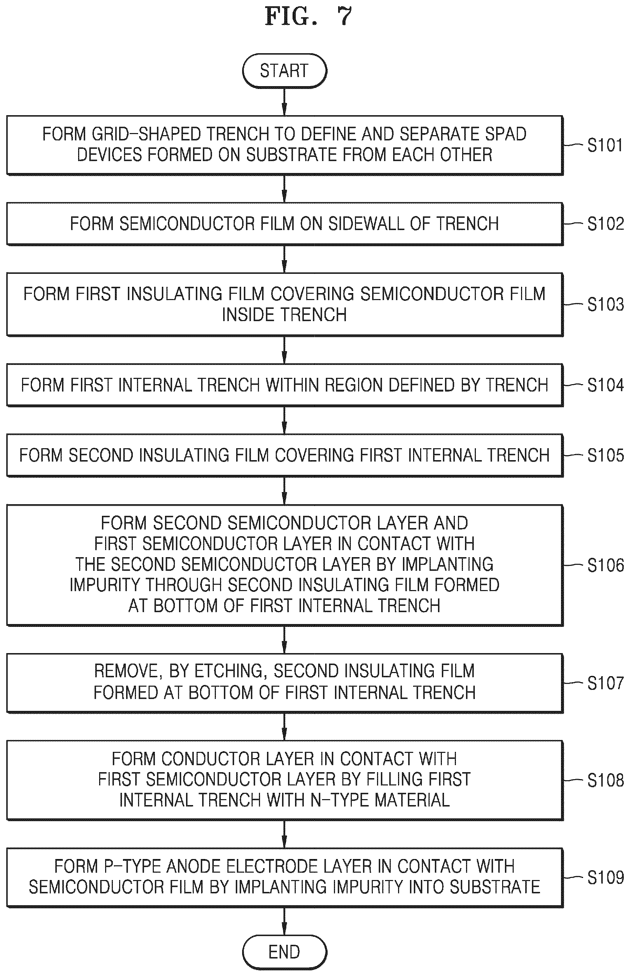

FIG. 7 is a flowchart illustrating the main process of a method of manufacturing the SPAD device 100 corresponding to FIG. 6.

The grid-shaped trench 103 is formed to define and separate the SPAD devices 100 formed on the semiconductor substrate 510 from each other (S101).

Next, the P-type semiconductor film 102 is formed on the sidewall of the trench 103 (S102).

Next, the first insulating film 101 covering the semiconductor film 102 is formed inside the trench 103 (S103).

Next, the first internal trench 112 is formed within the region defined by the trench (S104).

Next, the second insulating film 108 covering the first internal trench 112 is formed (S105).

Next, by sequentially implanting an acceptor and a donor, which are impurities, through the second insulating film 108 formed at the bottom of the first internal trench 112, the P-type second semiconductor layer 107 and the first semiconductor layer 106a in contact with the second semiconductor layer 107 are formed (S106).

Next, the second insulating film 108 formed at the bottom of the first internal trench 112 is removed by etching (S107).

Next, the first internal trench 112 is filled with an N-type material to form the conductor layer 106b in contact with the first semiconductor layer 106a (S108).

Next, by implanting an acceptor, which is an impurity, into the semiconductor substrate 510, the P-type anode electrode layer 105 in contact with the semiconductor film 102 is formed (S109).

### (Second embodiment)

Below, the second embodiment is described. The differences between the second embodiment and the first embodiment are as follows. In the present embodiment, the third semiconductor layer 113 is further included, and the third semiconductor layer 113 may contact the semiconductor films 102 facing each other on opposing sides of the SPAD device 100 (for example, the third semiconductor layer 113 may be connected to opposing sidewall portions of the semiconductor films 102) and may surround the second semiconductor layer 107 from a planar viewpoint. A distance from the second surface (e.g., the light incident surface) of the semiconductor substrate 510 of the third semiconductor layer 113 may be substantially equal to a distance from the second surface of the semiconductor substrate 510 of the second semiconductor layer 107. The third semiconductor layer 113 may be P-type.

In embodiments, as described above with reference to FIG. 5, electrons generated by photoelectric conversion may gather without an obstruction in the avalanche region 110 along the center of the photoelectric conversion region 109. In the periphery of the photoelectric conversion region 109, electrons generated by photoelectric conversion may move toward the avalanche region 110 due to the presence of the third semiconductor layer 113. For example, the third semiconductor layer 113 may function as a barrier that prevents electrons generated by photoelectric conversion from escaping to the cathode electrode layer 106 without passing through the avalanche region 110. In other respects, the present embodiment is identical to the first embodiment, so a redundant description is omitted.

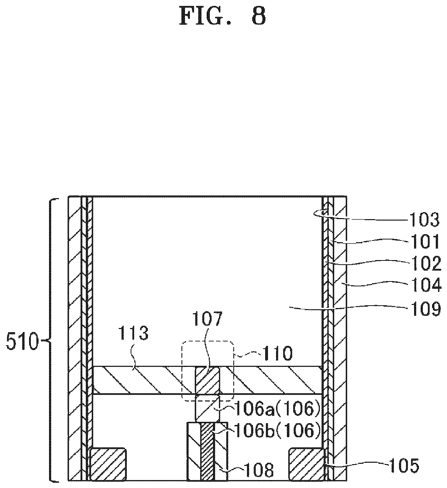

FIG. 8 is a cross-sectional view illustrating the structure of the SPAD device 100. The SPAD device 100 includes the third semiconductor layer 113 that is a P-type and connected to the opposing semiconductor film 102 and also overlaps the second semiconductor layer 107 in a horizontal direction. The horizontal direction may be a direction parallel the light incident surface and/or parallel to the device formation surface.

Below, a method of manufacturing the SPAD device 100 is described.

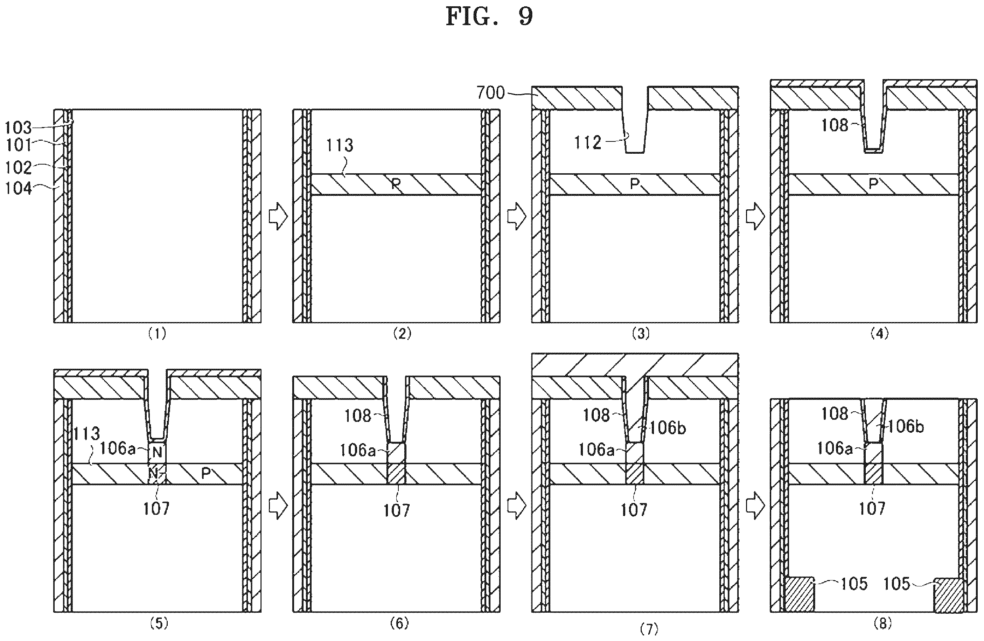

FIG. 9 is a diagram illustrating a method of manufacturing the SPAD device 100.

In operation 1, the trench 103 is formed to define and separate a plurality of SPAD devices formed on the semiconductor substrate 510 from each other, the semiconductor film 102 is formed on a sidewall of the formed trench 103, and the first insulating film 101 covering the formed semiconductor film 102 is formed inside the trench 103. In addition, the trench electrode layer 104 that is in contact with the first insulating film 101 may be formed within the trench 103.

In operation 2, the third semiconductor layer 113 that is a P-type and is connected to the opposing semiconductor film 102 is formed within the region defined by the trench 103 by implanting an acceptor, which is an impurity, into the semiconductor substrate 510 and activating the acceptor through heat treatment. For example, boron (B) is used as the acceptor.

In operation 3, the first internal trench 112 is formed within the region defined by the trench 103 using the hard mask material layer 700.

In operation 4, the second insulating film 108 covering the sidewall of the first internal trench 112 is formed.

In operation 5, the P-type second semiconductor layer 107 is formed in a portion of the third semiconductor layer 113 by implanting a donor, which is an impurity, through the second insulating film 108 formed at the bottom of the first internal trench 112 and activating the doner by heat treatment. For example, phosphorus (P) or arsenic (As) are used as the donor. As illustrated in FIG. 9, by adjusting the amount of donor implanted into a portion of the third semiconductor layer 113 to be relatively small to make the donor concentration of a part of the third semiconductor layer 113 forming the second semiconductor layer 107 relatively low, the second semiconductor layer 107 having a relatively low hole density and maintaining the P-type conductivity of the third semiconductor layer 113 may be formed. In this manner, a potential distribution in which electrons generated by photoelectric conversion may easily gather in the second semiconductor layer 107 may be achieved.

In addition, the first semiconductor layer 106a that is an N-type and in contact with the second semiconductor layer 107 is formed by implanting a donor, which is an impurity, through the second insulating film 108 formed at the bottom of the first internal trench 112 and activating the doner by heat treatment. For example, phosphorus (P) or arsenic (As) is used as the donor.

In addition, the heat treatment for forming the second semiconductor layer 107 and the first semiconductor layer 106a may be performed once after implanting the donor for forming the second semiconductor layer 107 and the donor for forming the first semiconductor layer 106a.

In operation 6, the second insulating film 108 formed at the bottom of the first internal trench 112 is removed by etching.

In operation 7, an N-type material is deposited on the semiconductor substrate 510 by a CVD process or the like, thereby filling the first internal trench 112 with the N-type material to form the conductor layer 106b in contact with the first semiconductor layer 106a.

In operation 8, the N-type material deposited on the semiconductor substrate 510 is removed so that the N-type material remains only within the first internal trench 112, and at the same time, the hard mask material layer 700 is removed.

Thereafter, by implanting an acceptor, which is an impurity, into the semiconductor substrate 510, the P-type anode electrode layer 105 in contact with the semiconductor film 102 is formed.

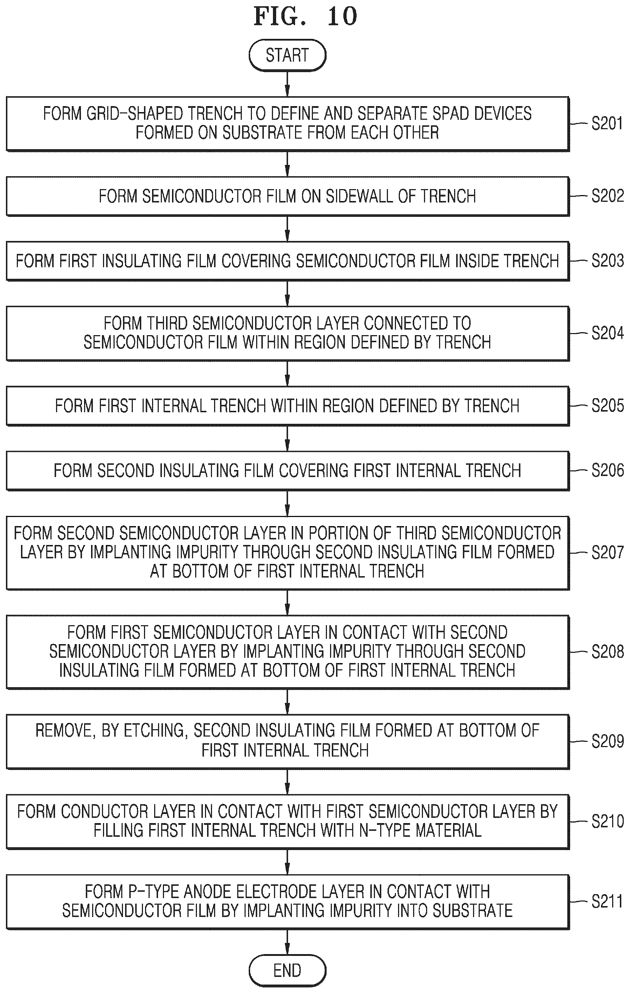

FIG. 10 is a flowchart illustrating the main process of a method of manufacturing the SPAD device 100 corresponding to FIG. 9.

The grid-shaped trench 103 is formed to define and separate the SPAD devices 100 formed on the semiconductor substrate 510 from each other (S201).

Next, the P-type semiconductor film 102 is formed on the sidewall of the trench 103 (S202).

Next, the first insulating film 101 covering the semiconductor film 102 is formed inside the trench 103 (S203).

Next, by implanting an acceptor, which is an impurity, the third semiconductor layer 113 that is a P-type and is connected to the opposing semiconductor film 102 is formed within the region defined by the trench 103 (S204).

Next, the first internal trench 112 is formed within the region defined by the trench 103 (S205).

Next, the second insulating film 108 covering the sidewall of the first internal trench 112 is formed (S206).

Next, the P-type second semiconductor layer 107 is formed in a portion of the third semiconductor layer 113 by implanting a donor, which is an impurity, through the second insulating film 108 formed at the bottom of the first internal trench 112 (S207).

Next, by implanting a donor, which is an impurity, through the second insulating film 108 formed at the bottom of the first internal trench 112, the first semiconductor layer 106a that is an N-type and in contact with the second semiconductor layer 107 is formed (S208).

Next, the second insulating film 108 formed at the bottom of the first internal trench 112 is removed by etching (S209).

Next, the first internal trench 112 is filled with an N-type material to form the conductor layer 106b in contact with the first semiconductor layer 106a (S210).

Next, by implanting an acceptor, which is an impurity, into the semiconductor substrate 510, a P-type anode electrode layer 105 in contact with the semiconductor film 102 is formed (S211).

### (Third embodiment)

The third embodiment is described. The differences between the third embodiment and the second embodiment are as follows. In the second embodiment, the second insulating film 108 is formed by depositing silicon oxide (SiO₂) on the sidewall of the first internal trench 112. By implanting a donor through the second insulating film 108 formed at the bottom of the second insulating film 108, the second semiconductor layer 107 and the first semiconductor layer 106a are formed. In addition, the conductor layer 106b is formed by filling the trench with an N-type material. Meanwhile, in the present embodiment, two trenches are formed, and the second insulating film 108 is formed by filling the two trenches with silicon oxide (SiO₂). In addition, the second semiconductor layer 107, the first semiconductor layer 106a, and the conductor layer 106b are formed by implanting a donor between the two trenches. In other respects, the present embodiment is the same as the second embodiment, so any redundant description is omitted or simplified.

A method of manufacturing the SPAD device 100 is described.

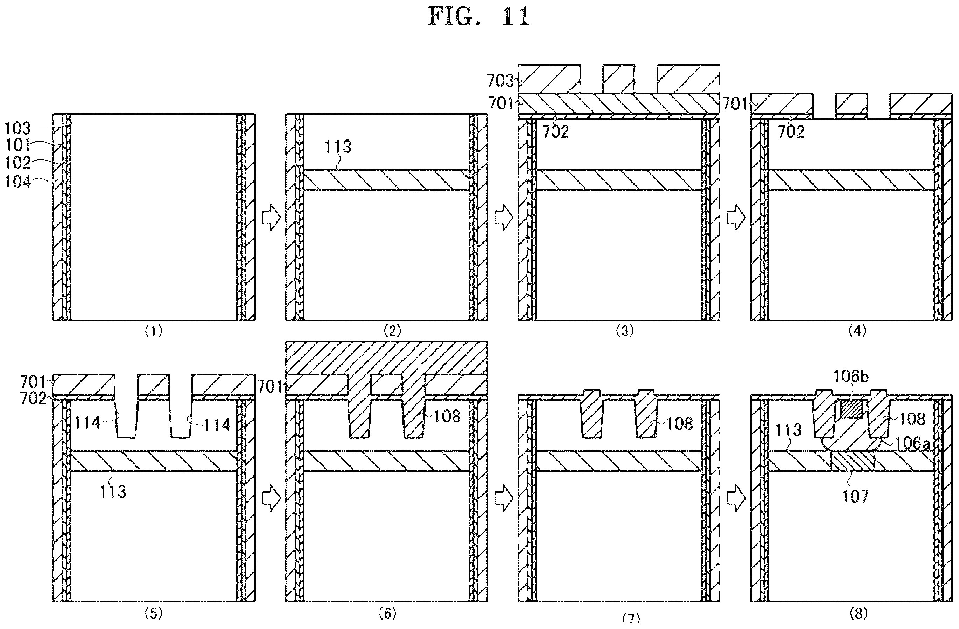

FIG. 11 is a diagram illustrating a method of manufacturing the SPAD device 100.

In operation 1, the trench 103 is formed to define and separate the SPAD devices formed on the semiconductor substrate 510 from each other, the semiconductor film 102 is formed on the sidewall of the formed trench 103, and the first insulating film 101 covering the formed semiconductor film 102 is formed inside the trench 103. In addition, the trench electrode layer 104 in contact with the first insulating film 101 may be formed inside the trench 103.

In operation 2, the third semiconductor layer 113 that is a P-type and is connected to the opposing semiconductor film 102 is formed within the region defined by the trench 103 by implanting an acceptor, which is an impurity, into the semiconductor substrate 510 and activating the acceptor through heat treatment. For example, boron (B) is used as the acceptor.

In operation 3, silicon oxide (SiO₂) is deposited as a fourth insulating film 702 on the semiconductor substrate 510, and a silicon nitride (SiN) layer 701 is deposited on the fourth insulating film 702. The silicon oxide (SiO₂) of the fourth insulating film 702 and the silicon nitride layer 701 are deposited by, for example, a CVD process. A resist 703 is formed on the silicon nitride layer 701 and patterned by etching. In detail, patterning is performed on the resist 703 to form openings corresponding to the positions of the two second internal trenches 114.

In operation 4, the fourth insulating film 702 and the silicon nitride layer 701 are patterned by etching using the patterned resist 703 as a mask. In detail, the silicon oxide (SiO₂) forming the fourth insulating film 702 and the silicon nitride layer 701 are patterned by removing portions of the fourth insulating film 702 and the silicon nitride layer 701 corresponding to the openings of the resist 703 by plasma etching. Accordingly, the openings corresponding to the positions of the two second internal trenches 114 are formed in the fourth insulating film 702 and the silicon nitride layer 701.

In operation 5, two second internal trenches 114 are formed by etching the semiconductor substrate 510 by plasma etching using the patterned fourth insulating film 702 and the silicon nitride layer 701 as masks. The two second internal trenches 114 are formed at a depth such that the bottom of the second internal trenches 114 does not contact the third semiconductor layer 113.

In operation 6, the second insulating film 108 is formed by filling two second internal trenches 114 with an insulating material by depositing an insulating material on the semiconductor substrate 510. For example, silicon oxide (SiO₂) may be used as the insulating material. The insulating material may be deposited on the semiconductor substrate 510, for example, by a CVD process.

In operation 7, the silicon nitride layer 701 on the semiconductor substrate 510 may be removed while simultaneously thinning the deposited insulating material. In detail, for example, the silicon nitride layer 701 may be removed using hot phosphoric acid, and the insulating material may be ground or thinned by a chemical mechanical polishing (CMP) process.

In operation 8, a donor, which is an impurity, is implanted through the fourth insulating film 702 between two second internal trenches 114 and activated by heat treatment to form the P-type second semiconductor layer 107 on a portion of the third semiconductor layer 113. For example, phosphorus (P) or arsenic (As) is used as the donor. By adjusting the amount of donor implanted into a portion of the third semiconductor layer 113 to be relatively small to make the donor concentration of a part of the third semiconductor layer 113 forming the second semiconductor layer 107 relatively low, the second semiconductor layer 107 having a relatively low hole density and maintaining the P-type conductivity of the third semiconductor layer 113 may be formed. In this manner, a potential distribution in which electrons generated by photoelectric conversion may easily gather in the second semiconductor layer 107 may be achieved.

In addition, a donor, which is an impurity, is implanted through the fourth insulating film 702 between the two second internal trenches 114 and activated by heat treatment to form the first semiconductor layer 106a that is N-type and in contact with the second semiconductor layer 107. For example, phosphorus (P) or arsenic (As) is used as the donor. Because the bottoms of the two second internal trenches 114 do not contact the third semiconductor layer 113, the first semiconductor layer 106a is formed so that at least a portion thereof is not covered by the second insulating film 108.

In addition, an N-type semiconductor layer in contact with the first semiconductor layer 106a is formed as the conductor layer 106b by implanting a donor, which is an impurity, through the fourth insulating film 702 between the two second internal trenches 114 and activating the doner through heat treatment. For example, phosphorus (P) or arsenic (As) is used as the donor.

In FIG. 11, it is illustrated that two second internal trenches 114 are arranged apart from each other and the conductor layer 106b is formed between the two second internal trenches 114. However, in some embodiments, the second internal trench 114 may have an annular or ring shape in a plan view, and an impurity implantation process may be performed through the fourth insulating film 702 inside the semiconductor substrate 510 defined by an inner wall of the annular second internal trench 114 to form the conductor layer 106b.

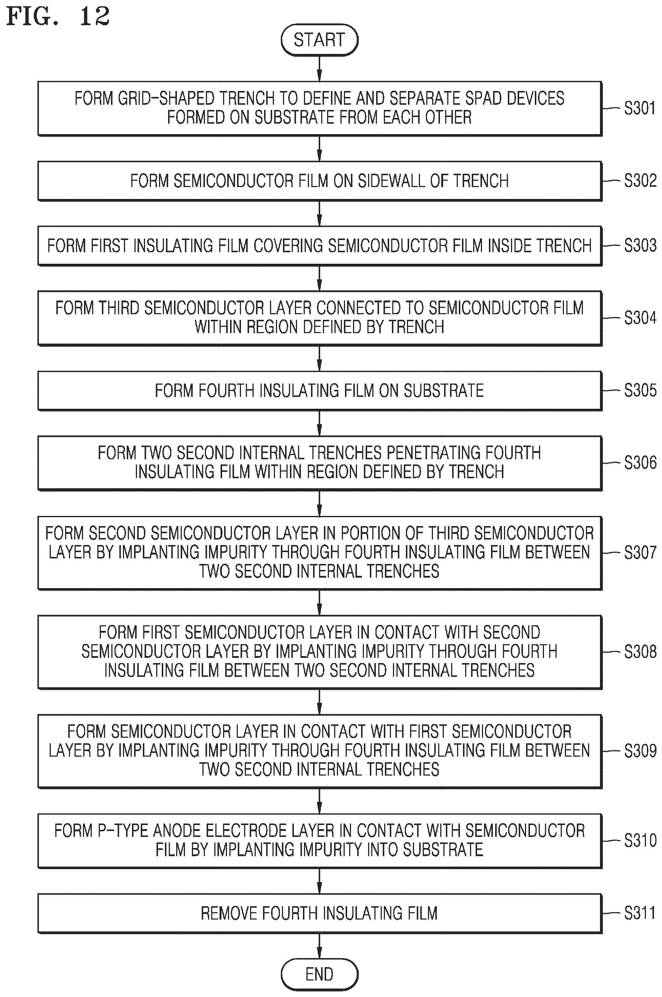

FIG. 12 is a flowchart illustrating the main process of a method of manufacturing the SPAD device 100 corresponding to FIG. 11.

The grid-shaped trench 103 is formed to define and separate the SPAD devices 100 formed on the semiconductor substrate 510 from each other (S301).

Next, the P-type semiconductor film 102 is formed on the sidewall of the trench 103 (S302).

Next, the first insulating film 101 covering the semiconductor film 102 is formed inside the trench 103 (S303).

Next, by implanting a donor, which is an impurity, the third semiconductor layer 113 that is a P-type and is connected to the opposing semiconductor film 102 is formed within a region defined by the trench 103 (S304).

Next, the fourth insulating film 702 is formed on the semiconductor substrate 510 (S305).

Next, two second internal trenches 114 penetrating the fourth insulating film 702 are formed within the region defined by the trench 103 (S306).

Next, the second semiconductor layer 107 is formed in a portion of the third semiconductor layer 113 by implanting a donor, which is an impurity, through the fourth insulating film 702 between the two second internal trenches 114 (S307).

Next, the first semiconductor layer 106a in contact with the second semiconductor layer 107 is formed by implanting a donor, which is an impurity, through the fourth insulating film 702 between the two second internal trenches 114 (S308).

Next, the conductor layer 106b in contact with the first semiconductor layer 106a is formed by implanting a donor, which is an impurity, through the fourth insulating film 702 between the two second internal trenches 114 (S309).

Next, by implanting an acceptor, which is an impurity, into the semiconductor substrate 510, the P-type anode electrode layer 105 in contact with the semiconductor film 102 is formed (S310).

Next, the fourth insulating film 702 is removed (S311).

### (Fourth embodiment)

Below, the fourth embodiment is described. The differences between the fourth embodiment and the third embodiment are as follows. In the third embodiment, the second semiconductor layer 107 is formed in a portion of the third semiconductor layer 113 by implanting a donor, which is an impurity, through the fourth insulating film 702 between two second internal trenches 114. Meanwhile, in the present embodiment, the third semiconductor layer 113 is not formed, and the second semiconductor layer 107 is formed by implanting an acceptor, which is an impurity, through the fourth insulating film 702 between the two second internal trenches 114. In other respects, the present embodiment is identical to the third embodiment, so a redundant description is omitted.

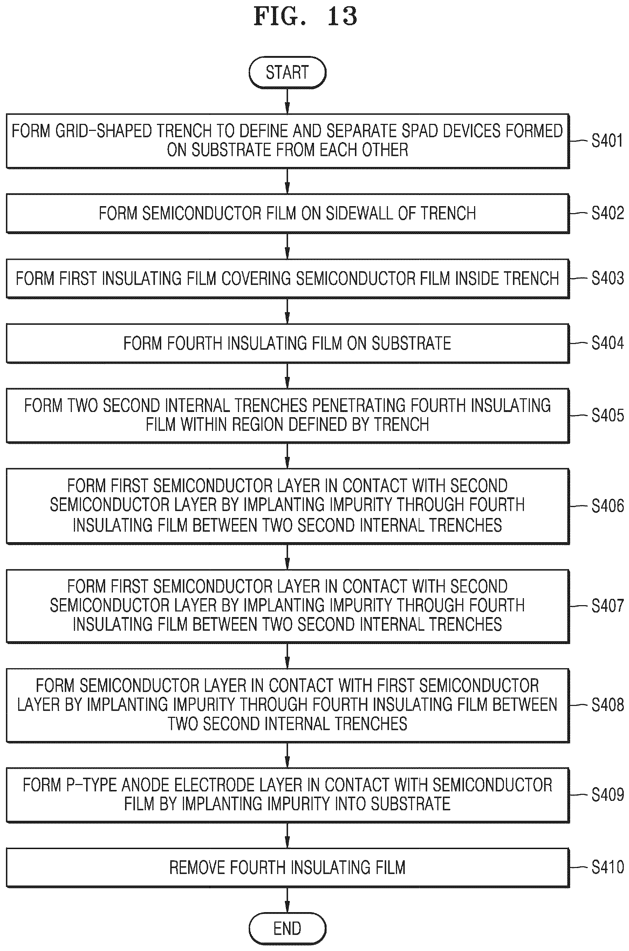

FIG. 13 is a flowchart illustrating the main process of a method of manufacturing the SPAD device 100.

Operations S401 to S405, S407 to S410 are identical to operations S301 to S303, S305, S306, S308 to S311 in FIG. 12, so the description is omitted. In addition, in the present embodiment, the operation corresponding to operation S304 in FIG. 12 is not executed.

In operation S406, the second semiconductor layer 107 is formed by implanting an acceptor, which is an impurity, through the fourth insulating film 702 between two second internal trenches 114.

### (Fifth embodiment)

Below, the fifth embodiment is described. The differences between the fifth embodiment and the first embodiment are as follows. In the first embodiment, the second insulating film 108 is apart from the anode electrode layer 105. Meanwhile, in the present embodiment, the second insulating film 108 is formed in a range close to or in contact with the anode electrode layer 105. In other respects, the present embodiment is identical to the first embodiment, so a redundant description is omitted.

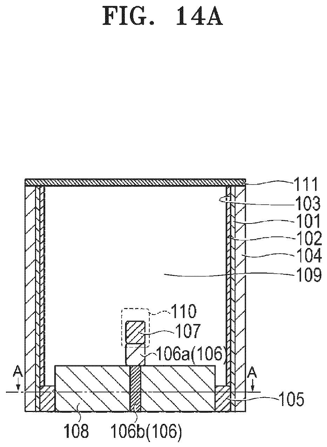

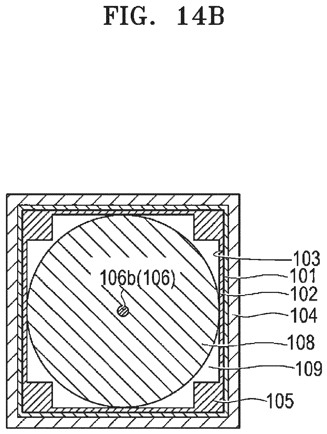

FIG. 14A is a cross-sectional view illustrating the structure of the SPAD device 100. FIG. 14B is a plan view taken along line A-A in FIG. 14A.

As shown in FIGS. 14A and 14B, the second insulating film 108 is formed to a range close to the anode electrode layer 105. As an example, the second insulating film 108 is formed in a circular shape when viewed from the A-A plane. In embodiments, the second insulating film 108 may be formed to have a relatively large area, such as 50% or more, 70% or more, or 90% or more of the area of the SPAD device 100 in a plan view. In this manner, the effect of reducing the capacitance of the cathode electrode may increase by the second insulating film 108, and further, low power consumption may be realized, and the potential of the anode electrode may be stably supplied to the semiconductor film 102.

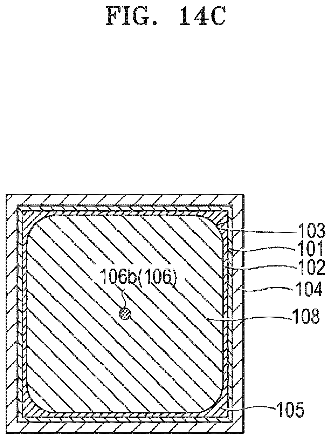

FIG. 14C is a plan view taken along line A-A in FIG. 14A illustrating another structure of the second insulating film 108.

As shown in FIG. 14C, the second insulating film 108 is matched to the shape of the trench 103. In embodiments, the sidewall of the second insulating film 108 may be arranged to be surrounded by the anode electrode layer 105 or the semiconductor film 102 in a plan view. By this structure, the distance between the anode electrode and the cathode electrode may increase, thereby realizing fine pixels.

### (Sixth embodiment)

Below, the sixth embodiment is described. The differences between the sixth embodiment and the first embodiment are as follows. In the present embodiment, a third insulating film 115, which is in contact with the anode electrode layer 105 and is apart from the second insulating film 108, is further included. In other respects, the present embodiment is identical to the first embodiment, so a redundant description is omitted.

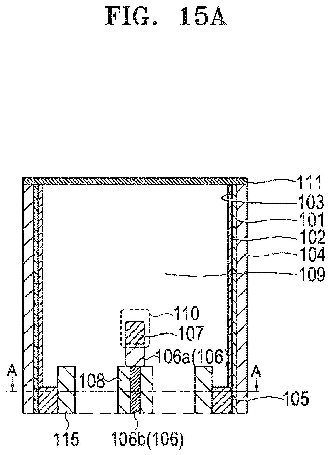

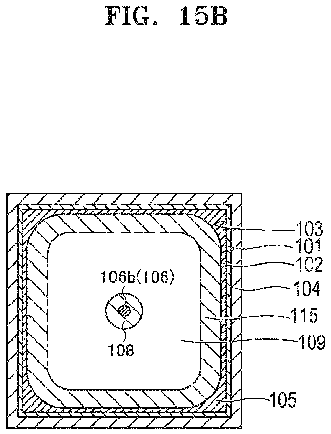

FIG. 15A is a cross-sectional view illustrating the structure of the SPAD device 100. FIG. 15B is a plan view taken along line A-A in FIG. 15A.

As illustrated in FIGS. 15A and 15B, the SPAD device 100 further includes a third insulating film 115 in contact with the anode electrode layer 105 and apart from the second insulating film 108, in addition to the second insulating film 108. Due to the presence of the third insulating film 115, the distance between the anode and the cathode in the SPAD device 100 may increase. That is, the distance contributing to the electric field (electric field intensity) between the anode electrode layer 105 and the portion (e.g., the first semiconductor layer 106a) of the cathode electrode layer 106 that is not covered with the second insulating film 108 may increase. Accordingly, the magnitude of the electric field between the anode and the cathode in the SPAD device 100 may be alleviated, thereby limiting and/or preventing deterioration of noise characteristics due to leakage current, etc.

The third insulating film 115 may be formed simultaneously with the second insulating film 108 by the same method as the method of forming the second insulating film 108 shown in FIG. 11.

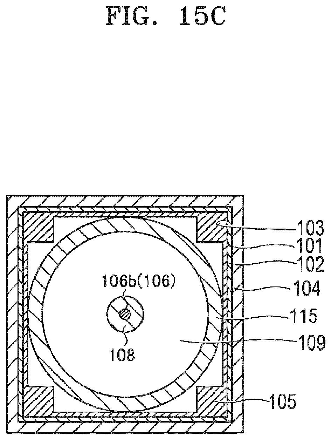

FIG. 15C is a plan view taken along line A-A in FIG. 15A illustrating another structure of the second insulating film 108.

As illustrated in FIG. 15C, by making the cross-sectional shape of the second insulating film 108 circular, the formation of corners that may cause electric field concentration may be suppressed, thereby limiting and/or preventing the occurrence of new sources of leakage current, etc.

In other embodiments, the third insulating film 115 may be positioned in any location between the anode electrode layer 105 and the second insulating film 108.

### (Seventh embodiment)

Below, the seventh embodiment is described. The differences between the seventh embodiment and the second embodiment are as follows. In the present embodiment, an N-type fourth semiconductor layer 116 with a lower impurity concentration than the first semiconductor layer 106a is further included in a region opposite to the light incident surface of the first semiconductor layer 106a. In other respects, the present embodiment is identical to the second embodiment, so a redundant description is omitted.

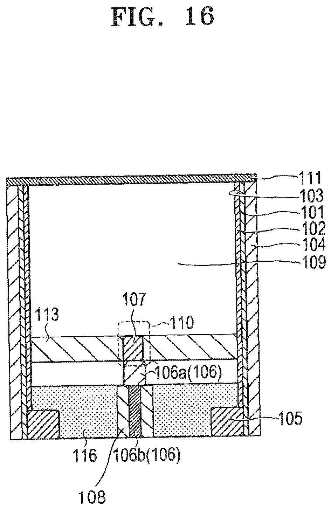

FIG. 16 is a cross-sectional view illustrating the structure of the SPAD device 100.

As illustrated in FIG. 16, the SPAD device 100 includes the N-type fourth semiconductor layer 116 having a lower donor concentration than the first semiconductor layer 106a that is an N-type, in a region opposite to the light incident surface of the first semiconductor layer 106a. Accordingly, a potential distribution that does not cause avalanche in a region other than the avalanche region 110 within the SPAD device 100 may be achieved.

### (Eighth embodiment)

Below, the eighth embodiment is described. The differences between the eighth embodiment and the second embodiment are as follows. In the present embodiment, a P-type fifth semiconductor layer 117 with a lower impurity concentration than the second semiconductor layer 107 is further included in a region opposite to the light incident surface of the first semiconductor layer 106a. In other respects, the present embodiment is identical to the second embodiment, so a redundant description is omitted.

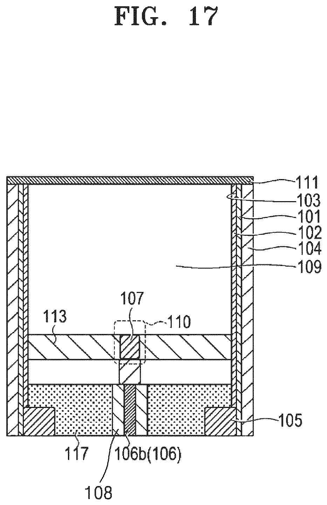

FIG. 17 is a cross-sectional view illustrating the structure of the SPAD device 100.

As illustrated in FIG. 17, the SPAD device 100 includes the P-type fifth semiconductor layer 117 having a lower acceptor concentration than the P-type second semiconductor layer 107 in a region opposite to the light incident surface of the second semiconductor layer 107. Accordingly, a potential distribution that does not cause avalanche in a region other than the avalanche region 110 within the SPAD device 100 may be achieved.

The SPAD device according to embodiments includes a semiconductor film of a first conductivity-type formed on a sidewall of a trench for separating the SPAD device from another SPAD device formed on a substrate, a first insulating film formed inside the trench and covering the semiconductor layer, an anode electrode layer which is of the first conductivity-type and in contact with the semiconductor film, a first semiconductor layer installed adjacent to a first surface of the substrate, and a conductor layer provided adjacent to a second surface and in contact with the first semiconductor layer, wherein a sidewall of the conductor layer includes a cathode electrode layer which is of a second conductivity-type and covered with a second insulating film and a second semiconductor layer which is of the first conductivity-type and in contact with the first semiconductor layer. Accordingly, deterioration of noise characteristics caused by leakage current, etc., may be prevented, noise caused by parasitic resistance, etc. may be reduced by miniaturizing the cathode electrode, and power consumption may be reduced by reducing the capacitance of the cathode electrode.

In addition, by forming the anode electrode layer to be in contact with the second surface, the distance between the anode and the cathode in the SPAD device may be easily widened, and the magnitude of the electric field may be effectively alleviated, thereby effectively limiting and/or preventing deterioration of noise characteristics caused by leakage current, etc.

In addition, the conductor layer includes at least one of single crystal silicon, polysilicon, or metal. In this manner, the structure of the conductor layer covered with the second insulating film may be easily formed, while reliability is ensured.

In addition, the width of the first semiconductor layer is set to be greater than or equal to the width of the conductor layer and less than or equal to the width of the combination of the conductor layer and the second insulating film. Accordingly, it is possible to easily achieve miniaturization of the cathode electrode while ensuring reliability. In addition, because defects that may occur at the cathode electrode may be reduced, deterioration of noise characteristics caused by leakage current, etc. may be further suppressed.

In addition, a first conductivity-type third semiconductor layer that is connected to the opposing semiconductor film and overlaps the second semiconductor layer is included. Accordingly, the sensitivity of the SPAD device may be improved.

In addition, a second conductivity-type fourth semiconductor layer having a lower impurity concentration than the first semiconductor layer or a first conductivity-type fifth semiconductor layer having a lower impurity concentration than the second semiconductor layer is included in a region adjacent to the second surface relative to the first semiconductor layer. Thus, a potential distribution that does not cause unnecessary avalanche in the SPAD device may be easily achieved.

In addition, the second insulating film is formed by a silicon oxide film. In this manner, the structure of the conductor layer covered with the second insulating film may be easily formed, while reliability is ensured.

In addition, the second insulating film is formed to be thick to the extent in contact with the anode electrode layer. This allows the cathode electrode to have a reduced capacitance.

In addition, the third insulating film apart from the second insulating film, which is in contact with the anode electrode layer or installed between the anode electrode layer and the second insulating film, is further included. As a result, the magnitude of an electric field between the anode and cathode in the SPAD device is alleviated, thereby limiting and/or preventing deterioration of noise characteristics caused by leakage current, etc.

While the inventive concept has been particularly shown and described with reference to embodiments thereof, it will be understood that various changes in form and details may be made therein without departing from the scope of the following claims.

## Claims

1. A single photon avalanche diode, SPAD, device (100) comprising:
a substrate (510) including a trench (103) for separating the SPAD device (100) from another SPAD device (100);
a semiconductor film (102) of a first conductivity-type on a sidewall of the trench (103);
a first insulating film (101) in the trench (103) and covering the semiconductor film (102);
an anode electrode layer (105) of the first conductivity-type, the anode electrode layer (105) being in contact with the semiconductor film (102);
a cathode electrode layer (106) positioned closer to a first surface of the substrate (510) compared to the anode electrode layer (105), the first surface of the substrate (510) being a light incident surface, the cathode electrode layer (106) having a first semiconductor layer (106a) of a second conductivity-type and a conductor layer (106b) in contact with the first semiconductor layer (106a), and the conductor layer (106b) being positioned closer to a second surface of the substrate (510) compared to the first semiconductor layer (106a), the second surface of the substrate (510) being opposite the first surface of the substrate (510);
a second insulating film (108) covering a sidewall of the conductor layer (106b); and
a second semiconductor layer (107) of the first conductivity-type, the second semiconductor layer (107) being in contact with the first semiconductor layer (106a).

2. The SPAD device (100) of claim 1, wherein the anode electrode layer (105) is coplanar with the second surface of the substrate (510).

3. The SPAD device (100) of claim 1 or 2, wherein the conductor layer (106b) includes at least one of single crystal silicon, polysilicon, or a metal.

4. The SPAD device (100) of any one of claims 1 to 3, wherein a width of the first semiconductor layer (106a) is greater than or equal to a width of the conductor layer (106b) and less than or equal to a width of a combination of the conductor layer (106b) and the second insulating film (108).

5. The SPAD device (100) of any one of claims 1 to 4, further comprising:
a third semiconductor layer (113) of the first conductivity-type, wherein
the third semiconductor layer (113) overlaps the second semiconductor layer (107) in a direction parallel to the first surface of the substrate (510), and
the third semiconductor layer (113) is connected to opposing sidewall portions of the semiconductor film (102).

6. The SPAD device of any one of claims 1 to 4, further comprising:
a third semiconductor layer (113) of the first conductivity-type and surrounding a sidewall of the second semiconductor layer (107) in a plan view, wherein a sidewall of the third semiconductor layer (113) contacts a sidewall of the semiconductor film (107).

7. The SPAD device of claim 6, wherein a bottom surface of the second semiconductor layer (107) is coplanar with a bottom surface of the third semiconductor layer (113).

8. The SPAD device (100) of any one of claims 1 to 7, wherein the second insulating film (108) includes a silicon oxide film.

9. The SPAD device (100) of any one of claims 1 to 8, wherein the second insulating film (108) extends to contact the anode electrode layer (105).

10. The SPAD device (100) of any one of claims 1 to 8, further comprising
a fourth semiconductor layer (116) of the second conductivity-type, the fourth semiconductor layer (116) being closer to the second surface of the substrate (510) compared to the first semiconductor layer (106a), and the fourth semiconductor layer (116) having a lower impurity concentration than an impurity concentration of the first semiconductor layer (106a), or
a fifth semiconductor layer (117) of the first conductivity-type, the fifth semiconductor layer (117) being positioned closer to the second surface of the substrate (510) than the first semiconductor layer (106a), and the fifth semiconductor layer (117) having a lower impurity concentration than an impurity concentration of the second semiconductor layer (107).

11. The SPAD device (100) of any of claims 1 to 10, further comprising:
a third insulating film (115) apart from the second insulating film (108), wherein
the third insulating film (115) is in contact with the anode electrode layer (105), or
the third insulating film (115) is between the anode electrode layer (105) and the second insulating film (108) and third insulating film (115) is spaced apart from the anode electrode layer (105).

12. The SPAD device (100) of any one of claims 1 to 11, wherein
the substrate (510) includes an internal trench (112) extending from the second surface into the substrate (510), and
the conductor layer (106b) and the second insulating film (108) are in the internal trench (112).

13. The SPAD device (100) of claim 12, wherein the second insulating film (108) is between the substrate (510) and the conductor layer (106b).

14. The SPAD device (100) of claim 12 or 13, wherein the first semiconductor layer (106a) vertically overlaps the internal trench (112).

15. The SPAD device (100) of claim 14, wherein a sidewall of the second insulating film (108) is surrounded by the semiconductor film (102) and the anode electrode layer (105) in a plan view.
